# EUROPEAN PATENT SPECIFICATION

(11) **EP 4 095 903 B1**
(45) Date of publication and mention of the grant of the patent: **28.01.2026**
(21) Application number: 21744347.2
(22) Date of filing: 20.01.2021
(51) Int. Cl.: H01L 23/50, G01N 3/24, H01L 21/56, G01N 19/04, G01N 1/28, H01L 23/31, H01L 23/373, H01L 23/495

(54) **METHOD FOR MANUFACTURING TEST PIECE FOR ADHESION EVALUATION TEST, AND ADHESION EVALUATION METHOD**
VERFAHREN ZUR HERSTELLUNG EINES PRÜFSTÜCKS FÜR EINE ADHÄSIONSBEURTEILUNGSPRÜFUNG UND ADHÄSIONSBEURTEILUNGSVERFAHREN
PROCÉDÉ DE FABRICATION DE PIÈCE D'ESSAI POUR ESSAI D'ÉVALUATION D'ADHÉRENCE, ET PROCÉDÉ D'ÉVALUATION D'ADHÉRENCE

(30) Priority: 24.01.2020 JP 2020009659
(43) Date of publication of application: 30.11.2022
(73) Proprietor: MITSUBISHI ELECTRIC CORPORATION, Chiyoda-ku Tokyo 100-8310 (JP)
(72) Inventor: IWAI, Takamasa, Tokyo 100-8310 (JP); FUJINO, Junji, Tokyo 100-8310 (JP); OMORI, Nobuhiko, Tokyo 100-8310 (JP)
(74) Representative: Diehl & Partner
(86) International application number: PCT/JP2021/001869
(87) International publication number: WO 2021/149728

(56) References cited:
- WO-A1-2007/061112
- JP-A- 2001 007 275
- JP-A- 2001 053 095
- JP-A- 2001 053 095
- JP-A- 2012 227 441
- JP-A- H11 263 826
- KR-A- 20170 039 063
- US-A1- 2007 075 050
- US-A1- 2014 030 827

## Description

### TECHNICAL FIELD

The present disclosure relates to a method for manufacturing a test piece for an adhesion evaluation test and an adhesion evaluation method.

### BACKGROUND ART

Semiconductor devices such as power modules are used in products such as industrial equipment, household electrical equipment, and information terminals. Generally, in the semiconductor device, a semiconductor element, a lead frame, an insulating substrate, and the like are sealed by a sealing resin for the purpose of protecting and insulating the semiconductor element, the lead frame, the insulating substrate, and the like. The sealing resin is required to have long-term reliability, reflow heat resistance, high reliability for a temperature cycle, and the like. For this reason, adhesion of the sealing resin to the lead frame, the insulating substrate, and the like are required to be quantitatively evaluated.

Generally, a pudding cup test is used as a method for evaluating the adhesion of the sealing resin. In the pudding cup test, a truncated cone-shaped test piece made of the same resin as the sealing resin is formed on the surface of a base member. A load is applied to the test piece along the surface of the base member, and the load during destruction of a bonding portion of the sealing resin is measured.

Japanese Patent Laying-Open No. 2014-146704 describes the pudding cup test.

KR 2017 0039063 A discloses a semiconductor device with an improved electromagnetic shielding and a manufacturing method of the semiconductor device.

JP 2001 053095 A discloses a method of removing a sealing resin of a semiconductor device via laser ablation.

US 2007/075050A1 discloses another method of removing a sealing resin of a semiconductor device via laser ablation.

JP 2012 227441 A discloses a manufacturing method for manufacturing a semiconductor element based on etching of an insulating material and filling the etched insulating material with conductive material.

US 2014/030827 A1 discloses a method of shearing an underfill material between a semiconductor element and a base member of a semiconductor device.

The pudding cup test is also described in a semiconductor equipment and materials international (SEMI) standard G69-0996.

### SUMMARY OF INVENTION

### TECHNICAL PROBLEM

In the pudding cup test described in JP 2014-146704, because a dedicated mold preparing the test piece for the pudding cup test is used, it is difficult to reproduce process conditions such as an injection condition in an actual mass production mold. Consequently, it is difficult to produce a test piece for an adhesion test in which a phenomenon generated in the actual mass production mold is directly reflected.

The SEMI standard G69-0996 does not describe a method for manufacturing the test piece for the pudding cup test.

The present disclosure has been made in view of the above problems, and an object of the present disclosure is to provide a method for manufacturing the test piece for the adhesion test in which the phenomenon generated in the actual mass production mold is directly reflected, and an adhesion evaluation method.

### SOLUTION TO PROBLEM

For solving the technical problem described above, the present application discloses a method for manufacturing a test piece for an adhesion evaluation test, wherein the method is defined by the features of independent claim 1. Advantageous embodiments of the method for manufacturing a test piece for an adhesion evaluation test are defined by the features of the dependent claims 2 to 5. The method for manufacturing a test piece for an adhesion evaluation test of the present disclosure includes preparing a semiconductor device and forming a test piece for the adhesion evaluation test. In preparing the semiconductor device, the semiconductor device includes a base member, a semiconductor element mounted on the base member, and a sealing resin to seal the base member and the semiconductor element. In forming the test piece for the adhesion evaluation test, the test piece for the adhesion evaluation test is formed on the base member or on an insulating member under the base member from the sealing resin of the semiconductor device.

### ADVANTAGEOUS EFFECTS OF INVENTION

According to the method for manufacturing the test piece for the adhesion evaluation test of the present disclosure, the test piece for the adhesion evaluation test is formed on the base member or on an insulating member under the base member from the sealing resin of the semiconductor device. Thus, the test piece for the adhesion evaluation test can be formed on the base member or on an insulating member under the base member from the sealing resin of the semiconductor device formed in the actual mass production mold. Consequently, it is possible to provide the method for manufacturing the test piece for the adhesion test and the adhesion evaluation method in which the phenomenon generated in the actual mass production mold is directly reflected.

### BRIEF DESCRIPTION OF DRAWINGS

Fig. 1 is a flowchart illustrating a method for manufacturing a test piece for an adhesion evaluation test according to a first embodiment.
Fig. 2 is a perspective view illustrating a process of preparing a semiconductor device in the method for manufacturing the test piece for the adhesion evaluation test of the first embodiment.
Fig. 3 is a sectional view taken along a line III-III in Fig. 2.
Fig. 4 is a sectional view taken along a line IV-IV of Fig. 2.
Fig. 5 is a sectional view illustrating a process of forming the test piece for the adhesion evaluation test in the method for manufacturing the test piece for the adhesion evaluation test of the first embodiment.
Fig. 6 is a sectional view illustrating a state in which a sealing resin is further removed from Fig. 5 to form the test piece.
Fig. 7 is a perspective view illustrating the test piece for the adhesion evaluation test of the first embodiment.
Fig. 8 is a plan view illustrating a semiconductor device on which the test piece for the adhesion evaluation test of the first embodiment is formed.
Fig. 9 is a flowchart illustrating an adhesion evaluation method of the first embodiment.
Fig. 10 is a sectional view illustrating a process of measuring shear peeling strength in the adhesion evaluation method of the first embodiment.
Fig. 11 is a sectional view illustrating a first modification of the method for manufacturing the test piece for the adhesion evaluation test of the first embodiment.
Fig. 12 is a sectional view illustrating a state in which the sealing resin is further removed from Fig. 11 to form the test piece.
Fig. 13 is a plan view illustrating a second modification of the method for manufacturing the test piece for the adhesion evaluation test of the first embodiment.
Fig. 14 is a sectional view illustrating a third modification of the method for manufacturing the test piece for the adhesion evaluation test of the first embodiment.
Fig. 15 is a sectional view illustrating a state in which a mask is removed from Fig. 14 to form the test piece.
Fig. 16 is a sectional view illustrating a process of preparing a semiconductor device in a method for manufacturing a test piece for an adhesion evaluation test according to a second embodiment.
Fig. 17 is a sectional view illustrating a process of forming the test piece for the adhesion evaluation test in the method for manufacturing the test piece for the adhesion evaluation test of the second embodiment.
Fig. 18 is a graph illustrating a relationship between a laser irradiation time and the shear peeling strength in an example.
Fig. 19 is a photograph illustrating an appearance of the test piece and an appearance of an adhesive portion after a shear test.
Fig. 20 is a sectional view illustrating a state in which unevenness of the sealing resin exists around the test piece of the example.
Fig. 21 is a graph illustrating the relationship between a diameter of the test piece and the shear peeling strength in the example.
Fig. 22 is a photograph illustrating an appearance after a shear peeling test when the diameters of the test pieces are 1.94 mm and 0.9 mm.
Fig. 23 is a sectional view illustrating a method for measuring the shear peeling strength of the test piece in the example.
Fig. 24 is a graph illustrating the relationship between a direction in which the test piece is pushed by a tool and the shear peeling strength.
Fig. 25 is a perspective view illustrating a shape of the test piece and the direction in which the test piece is pushed by the tool.
Fig. 26 is a graph illustrating a relationship between a casting speed and a peeling rate.
Fig. 27 is a graph illustrating a relationship between the casting speed and the shear peeling strength.
Fig. 28 is a graph illustrating a relationship between the peeling rate and the shear peeling strength.
Fig. 29 is a sectional view illustrating a process of preparing a semiconductor device in a method for manufacturing a test piece for an adhesion evaluation test according to a third embodiment.
Fig. 30 is a sectional view illustrating a process of forming the test piece for the adhesion evaluation test in the method for manufacturing the test piece for the adhesion evaluation test of the third embodiment.
Fig. 31 is a sectional view illustrating a process of measuring shear peeling strength in the adhesion evaluation method of the third embodiment.

### DESCRIPTION OF EMBODIMENTS

Hereinafter, embodiments will be described with reference to the drawings. In the following description, the same or corresponding parts are denoted by the same reference numerals, and overlapping description will not be repeated.

### First embodiment

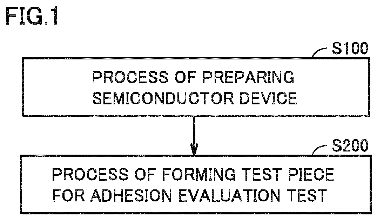

With reference to Figs. 1 to 10, a method for manufacturing a test piece for an adhesion evaluation test and an adhesion evaluation method according to a first embodiment will be described.

With reference to Figs. 1 to 7, the method for manufacturing the test piece for the adhesion evaluation test of the first embodiment will be described below. With reference to Fig. 1, the method for manufacturing the test piece for the adhesion evaluation test of the first embodiment includes a process S 100 of preparing a semiconductor device 1 and a process S200 of forming a test piece 72 for the adhesion evaluation test.

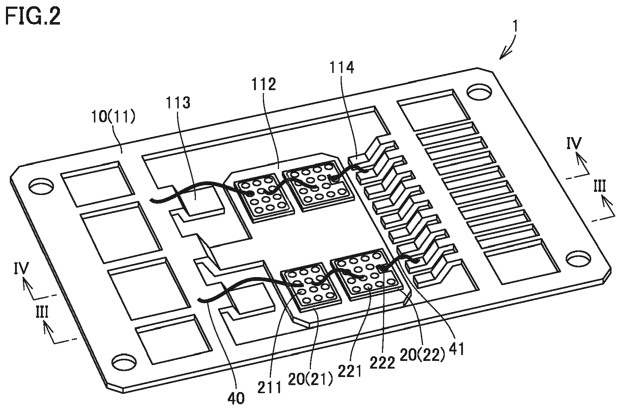

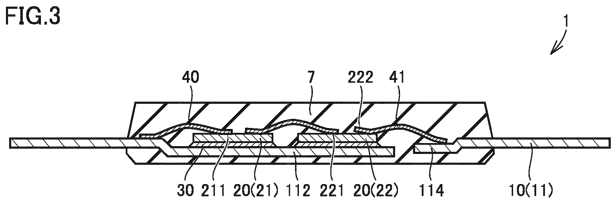

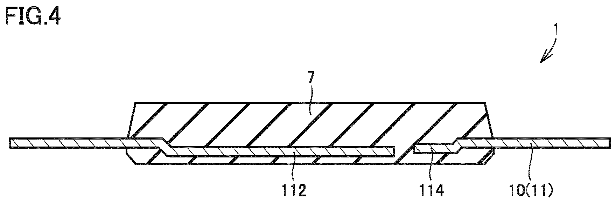

With reference to Figs. 2 to 4, a process of preparing a semiconductor device in the method for manufacturing the test piece for the adhesion evaluation test of the first embodiment will be described. Fig. 2 is a perspective view illustrating semiconductor device 1 in the method for manufacturing the test piece for the adhesion evaluation test of the first embodiment. In Fig. 2, a sealing resin is not illustrated for easy viewing of an internal structure. Fig. 3 is a sectional view taken along a line III-III of Fig. 2. Fig. 4 is a sectional view taken along a line IV-IV of Fig. 2. Fig. 4 illustrates a section of a central portion of a lead frame.

Semiconductor device 1 includes a base member 10, a semiconductor element 20, solder 30, wires 40, 41, and a sealing resin 7. For example, semiconductor device 1 is a power module for power.

In the first embodiment, base member 10 is a lead frame 11. For example, a material for lead frame 11 is copper. For example, dimensions of lead frame 11 are 120 mm in length, 75 mm in width, and 0.6 mm in thickness. Lead frame 11 includes a die pad 112, a main electrode terminal 113, and a signal terminal 114 such as a gate electrode terminal.

Semiconductor element 20 is mounted on base member 10. For example, semiconductor element 20 is a power semiconductor element for power. In the first embodiment, semiconductor element 20 includes a diode 21 and an insulated gate bipolar transistor (IGBT) 22. For example, dimensions of diode 21 are 15 mm in length, 13 mm in width, and 0.2 mm in thickness. For example, dimensions of IGBT 22 are 15 mm in length, 15 mm in width, and 0.2 mm in thickness. Diode 21 and IGBT 22 are die-bonded to die pad 112 of lead frame 11 with solder 30.

A metal oxide semiconductor field effect transistor (MOSFET) or the like can be used as semiconductor element 20.

Semiconductor element 20 may be a power semiconductor element using silicon (Si). In addition, semiconductor element 20 may be a wide band gap compound semiconductor using silicon carbide (SiC), gallium nitride (GaN), gallium arsenide (GaAs), or the like.

On die pad 112 of lead frame 11, two diodes 21 and two IGBTs 22 are die-bonded by solder 30. For example, a composition ratio of solder 30 is 96.5 mass% of tin (Sn), 3 mass% of silver (Ag), and 0.5 mass% of copper (Cu). For example, a melting point of solder 30 is 217 °C.

For example, the composition ratio of solder 30 may be 98.5 mass% of tin (Sn), 1 mass% of silver (Ag), and 0.5 mass% of copper (Cu). For example, the composition ratio of solder 30 may be 96 mass% of tin (Sn), 3 mass% of antimony (Sb), and 1 mass% of silver (Ag).

In addition, a copper (Cu)-tin (Sn) paste in which a copper powder is dispersed to obtain high heat resistance by isothermal solidification, or a nano-silver paste joined using low temperature firing of nano-silver particles may be used instead of solder 30.

A main electrode 211 of diode 21 and a main electrode 221 of IGBT 22 are electrically connected to lead frame 11 using wire 40. For example, the material of wire 40 is aluminum. For example, the diameter of wire 40 is 0.3 mm.

A signal electrode 222 such as a gate electrode of IGBT 22 is electrically connected to lead frame 11 using wire 41. For example, the material of wire 41 is aluminum. For example, the diameter of wire 41 is 0.15 mm.

For example, the material of wires 40, 41 may be copper (Cu), gold (Au), or Ag (silver). In addition, wires 40, 41 may be aluminum (Al)-coated copper (Cu) wires.

Instead of using wire bonding for circuit formation, ribbon bonding may be used, or the semiconductor element may be directly soldered to a plate-shaped electrode plate.

Sealing resin 7 seals base member 10, semiconductor element 20, solder 30, and wires 40, 41. Heated sealing resin 7 is pressure-injected and then heat-cured while lead frame 11, semiconductor element 20, solder 30, and wires 40, 41 are sandwiched between molds (not illustrated), whereby resin sealing is completed. For example, the mold (not illustrated) is heated to 170 °C. For example, sealing resin 7 is heated to 170 °C. For example, sealing resin 7 is an epoxy transfer mold resin containing a silica filler. For example, sealing resin 7 is, pressure-injected and then heat-cured in an oven at 170 °C for 4 hours.

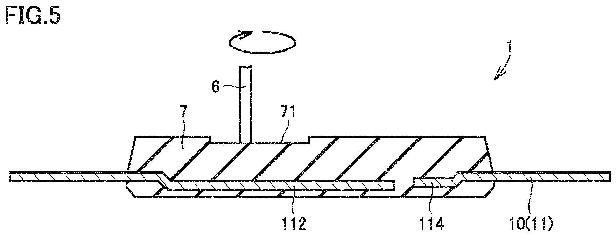

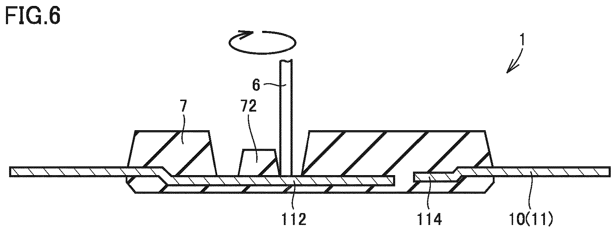

With reference to Figs. 5 and 6, a process of forming the test piece for the adhesion evaluation test of the first embodiment will be described. Figs. 5 and 6 are sectional views at sectional positions corresponding to Fig. 4.

As illustrated in Figs. 5 and 6, in the process of forming the test piece for the adhesion evaluation test of the first embodiment, test piece 72 for the adhesion evaluation test is formed on base member 10 from sealing resin 7 of semiconductor device 1.

As illustrated in Fig. 5, test piece 72 is formed from sealing resin 7 by processing using a laser beam 6. Laser beam 6 is a laser for opening the sealing resin. First, sealing resin 7 is removed in a circular shape using laser beam 6 to form a recess 71. For example, an outermost surface diameter of recess 71 is 5.0 mm.

For example, an irradiation device of laser beam 6 is F/Alit manufactured by Shinohara Japan Co., Ltd. For example, a wavelength of laser beam 6 is 1064 nm. For example, maximum output of the laser beam 6 is 20 W.

As illustrated in Fig. 6, sealing resin 7 is further removed, and an outer peripheral portion is removed while the central portion of test piece 72 is left at a point of time when the remaining height of sealing resin 7 becomes, for example, 1.5 mm. For example, the diameter of the central portion of test piece 72 is 1.5 mm. In this way, test piece 72 is manufactured.

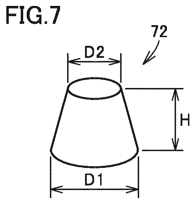

With reference to Figs. 6 and 7, test piece 72 is formed in a pudding cup shape. That is, test piece 72 is formed in a truncated cone shape. For example, a diameter D1 of the lead frame interface of test piece 72 is 1.94 mm. For example, a diameter D2 of the surface of test piece 72 is 1.5 mm. For example, a height H of test piece 72 is 1.5 mm.

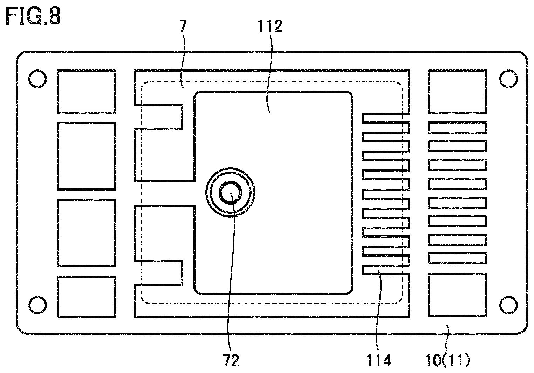

With reference to Fig. 8, semiconductor device 1 on which test piece 72 is formed will be described. Sealing resin 7 hardly remains around truncated cone-shaped test piece 72. Alternatively, die pad 112 is exposed from sealing resin 7 around truncated cone-shaped test piece 72. Fig. 8 is a top view illustrating semiconductor device 1 in which test piece 72 is formed in the method for manufacturing the test piece for the adhesion evaluation test of the first embodiment. In Fig. 8, for easy viewing, a part of sealing resin 7 is indicated by a broken line, lead frame 11 inside sealing resin 7 is indicated by a solid line, and semiconductor element 20 and the like are not illustrated.

An adhesion evaluation method of the first embodiment will be described below.

In the adhesion evaluation method of the first embodiment, the adhesion is evaluated using the test piece manufactured by the method for manufacturing the test piece for the adhesion evaluation test.

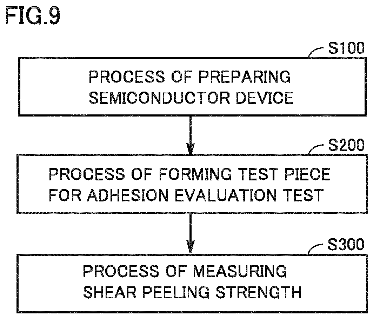

With reference to Fig. 9, the adhesion evaluation method of the first embodiment includes process S100 of preparing semiconductor device 1, process S200 of forming test piece 72 for the adhesion evaluation test, and a process S300 of measuring the shear peeling strength.

Because process S 100 of preparing semiconductor device 1 and process S200 of forming test piece 72 for the adhesion evaluation test are the same as the method of manufacturing the test piece for the adhesion evaluation test described above, the description thereof will not be repeated.

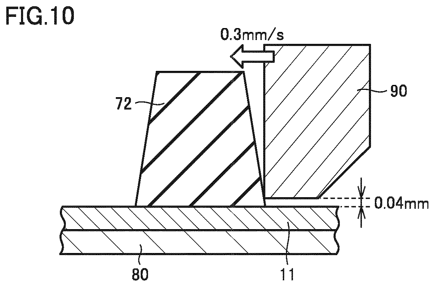

With reference to Fig. 10, the process of measuring the shear peeling strength of the first embodiment will be described. In the process of measuring the shear peeling strength of the first embodiment, the shear peeling strength is measured using test piece 72 for the adhesion evaluation test. Semiconductor device 1 in which test piece 72 is provided is fixed to a mounting table 80. In this state, test piece 72 is pushed by tool 90 until test piece 72 is broken.

For example, a device used for evaluating the shear peeling strength is bond tester DAGE4000 manufactured by DAGE. For example, the shear peeling strength test is performed at normal temperature. For example, the height of the tip end of tool 90 is set to the height of 0.04 mm from lead frame 11. For example, the shear rate pressing tool 90 is 0.3 mm/s. An adhesive area of each sample is calculated after break of test piece 72, and a value obtained by dividing a breaking load by the adhesive area is defined as the shear peeling strength (Kg/mm).

The shear peeling strength test is not limited to room temperature. The shear peeling strength test is performed at a high temperature such as 50 °C or 100 °C as necessary, whereby the adhesion in an actual use environment can be evaluated.

An advantageous effect of the first embodiment will be described below.

According to the method for manufacturing test piece 72 for the adhesion evaluation test of the first embodiment, test piece 72 for the adhesion evaluation test is formed on base member 10 from sealing resin 7 of semiconductor device 1. Thus, test piece 72 for the adhesion evaluation test can be formed on base member 10 from sealing resin 7 of semiconductor device 1 formed in the actual mass production mold. Consequently, it is possible to provide the method for manufacturing test piece 72 for the adhesion test in which the phenomenon generated in the actual mass production mold is directly reflected.

In the method for manufacturing test piece 72 for the adhesion evaluation test of the first embodiment, test piece 72 is formed from sealing resin 7 by processing using laser beam 6. Consequently, test piece 72 can be formed from sealing resin 7 by processing using the laser beam. In addition, because test piece 72 is formed of sealing resin 7 by processing using the laser beam, dimensional accuracy of test piece 72 can be improved.

According to the adhesion evaluation method of the first embodiment, test piece 72 for the adhesion evaluation test is formed on base member 10 from sealing resin 7 of semiconductor device 1. The shear peeling strength is measured using test piece 72 for the adhesion evaluation test. Consequently, the adhesion evaluation method in which the phenomenon generated in the actual mass production mold is directly reflected can be provided.

In the first embodiment, test piece 72 may be manufactured on not only die pad 112 but also signal terminal 114. According to the first embodiment, test piece 72 can be manufactured at an arbitrary position on the lead frame 11, and the adhesion can be evaluated at a pinpoint of a place where the peeling between sealing resin 7 and lead frame 11 is easily generated in tests of long-term reliability and reflow heat resistance.

Lead frame 11 may be plated with silver (Ag), gold (Au), nickel (Ni), tin (Sn), or the like. Generally, it is known that the adhesion to sealing resin 7 on these plating members is lower than that of copper (Cu). According to the first embodiment, in combination with a plating member, the adhesion can be evaluated at the pinpoint of the place where the peeling between sealing resin 7 and lead frame 11 is easily generated in the tests of the long-term reliability and reflow heat resistance.

In the first embodiment, the adhesion at the position where the product is easily peeled off or the adhesion at the position where the adhesion of the product is low can be evaluated.

Furthermore, the process condition during transfer molding is changed to use the first embodiment, so that the difference in adhesion due to the process condition that cannot be conventionally evaluated can be evaluated. Thus, an appropriate process condition can be determined before reliability is input, so that a development period can be shortened.

Modification of the method for manufacturing the test piece for the adhesion evaluation test of the first embodiment will be described.

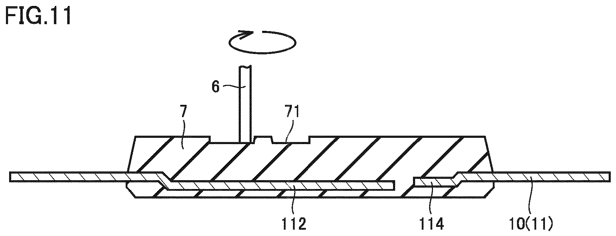

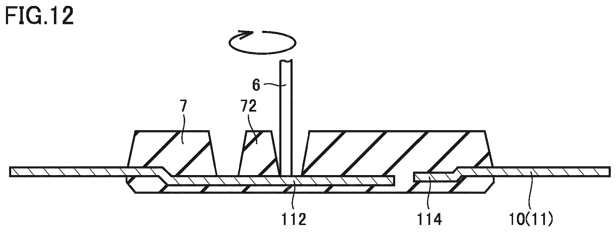

With reference to Figs. 11 to 12, a first modification of the method for manufacturing the test piece for the adhesion evaluation test of the first embodiment will be described. Figs. 11 and 12 are sectional views at sectional positions corresponding to Fig. 5. In the first modification of the method for manufacturing the test piece for the adhesion evaluation test of the first embodiment, as illustrated in Fig. 11, the outer peripheral portion of test piece 72 is removed from the beginning. As illustrated in Fig. 12, sealing resin 7 is further removed to manufacture test piece 72. In this way, test piece 72 may be manufactured by removing only the outer peripheral portion of test piece 72 from the beginning.

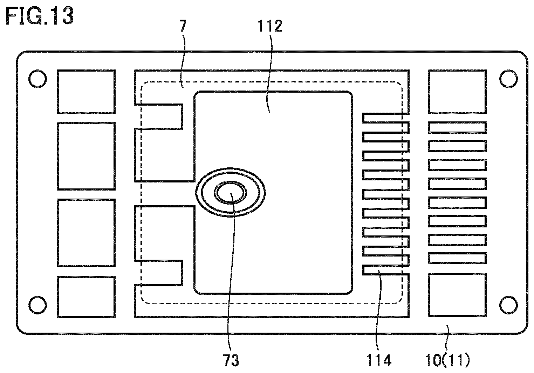

With reference to Fig. 13, a second modification of the method for manufacturing the test piece for the adhesion evaluation test of the first embodiment will be described. Fig. 13 is a top view illustrating semiconductor device 1 in the second modification of the method for manufacturing the test piece for the adhesion evaluation test of the first embodiment. In Fig. 13, for easy viewing, a part of sealing resin 7 is indicated by the broken line, lead frame 11 inside sealing resin 7 is indicated by the solid line, and semiconductor element 20 and the like are not illustrated.

In the second modification of the method for manufacturing the test piece for the adhesion evaluation test of the first embodiment, test piece 72 is formed in an elliptical truncated cone shape. The bottom surface and the top surface of test piece 72 may be formed in an oval or rounded rectangular shape. Around elliptical truncated cone-shaped test piece 72, sealing resin 7 hardly remains or die pad 112 is exposed from sealing resin 7.

In elliptical truncated cone-shaped test piece 72, for example, the dimension (major axis) in a longitudinal direction is 1.5 times the dimension (minor axis) in a lateral direction.

In the second modification of the method for manufacturing the test piece for the adhesion evaluation test of the first embodiment, test piece 72 is formed in an elliptical truncated cone shape. The shear peeling strength is measured in the longitudinal direction of test piece 72, so that the evaluation in which an increase in strength due to deflection is removed can be performed when the adhesion of the minute region is evaluated.

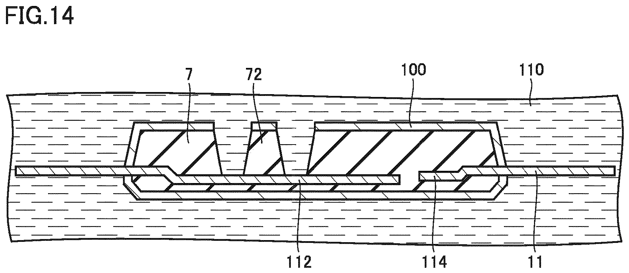

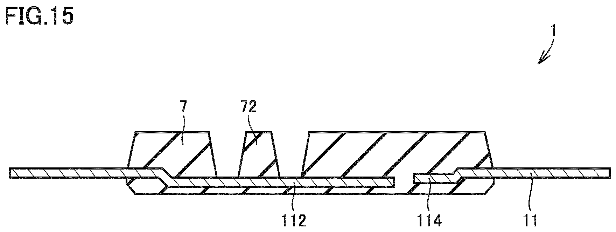

With reference to Figs. 14 to 15, a third modification of the method for manufacturing the test piece for the adhesion evaluation test of the first embodiment will be described. Figs. 14 and 15 are sectional views at sectional positions corresponding to Fig. 5. In the third modification of the method for manufacturing the test piece for the adhesion evaluation test of the first embodiment, test piece 72 is formed from sealing resin 7 by processing using etching solution 110.

As illustrated in Fig. 14, first, a mask 100 is formed on sealing resin 7. Mask 100 is formed so as not to cover the periphery of test piece 72. Etching solution 110 dissolves sealing resin 7. Sealing resin 7 is etched into a truncated cone shape by etching solution 110.

As illustrated in Fig. 15, after sealing resin 7 is etched into a truncated cone shape by etching solution 110, mask 100 is removed. Thus, the truncated cone-shaped test piece 72 is formed.

According to the third modification of the method for manufacturing the test piece for the adhesion evaluation test of the first embodiment, test piece 72 is formed from sealing resin 7 by processing using an etching solution. Thus, test piece 72 can be manufactured in a larger amount at one time than the case where test piece 72 is formed of sealing resin 7 by processing using a laser.

### Second embodiment

A second embodiment has the same configuration, operation, and effect as those of the first embodiment described above unless otherwise specified. Consequently, in the second embodiment, the same component as that in the first embodiment is denoted by the same reference numeral, and the description thereof will not be repeated.

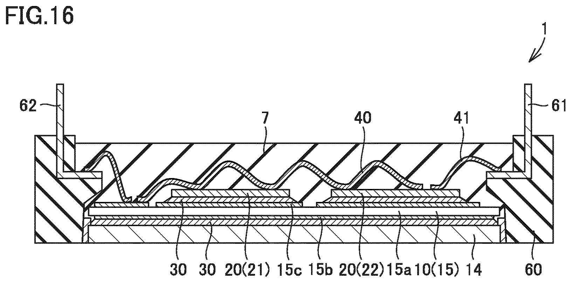

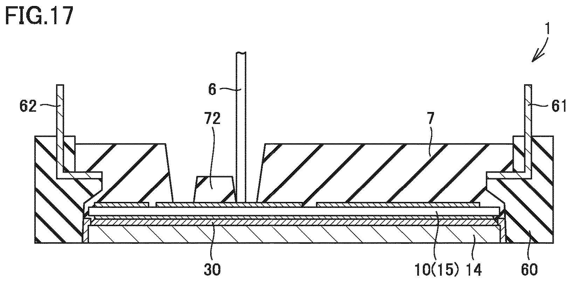

With reference to Figs. 16 and 17, a method for manufacturing the test piece for the adhesion evaluation test of the second embodiment will be described. An adhesion evaluation method of the second embodiment is the same as the adhesion evaluation method of the first embodiment unless otherwise specified.

With reference to Fig. 16, a process of preparing the semiconductor device in the method for manufacturing the test piece for the adhesion evaluation test according to the second embodiment will be described. Fig. 16 is a sectional view illustrating semiconductor device 1 in the method for manufacturing the test piece for the adhesion evaluation test of the second embodiment.

Semiconductor device 1 includes base member 10, a base plate 14, semiconductor element 20, solder 30, wires 40, 41, sealing resin 7, a case 60, a signal terminal 61, and a main electrode terminal 62.

In the second embodiment, base member 10 is a ceramic substrate 15. Ceramic substrate 15 includes a main body 15a and conductor layers 15b, 15c. Conductor layers 15b, 15c are attached to both surfaces of main body 15a, respectively. For example, the material of main body 15a is aluminum nitride ceramic. The outer dimensions of main body 15a are 35 mm in length, 65 mm in width, and 0.64 mm in thickness. For example, the material of conductor layers 15b, 15c is copper. The outer dimensions of conductor layers 15b, 15c are 31 mm in length, 61 mm in width, and 0.4 mm in thickness.

Ceramic substrate 15 is bonded onto base plate 14 with solder 30. Specifically, conductor layer 15b of ceramic substrate 15 is bonded to base plate 14 with solder 30. For example, the material of base plate 14 is copper.

In the second embodiment, semiconductor element 20 includes diode 21 and IGBT 22. For example, the dimensions of the diode 21 are 13 mm in length, 10 mm in width, and 0.2 mm in thickness. For example, the dimensions of IGBT 22 are 13 mm in length, 13 mm in width, and 0.2 mm in thickness. Diode 21 and IGBT 22 are bonded onto conductor layer 15c of ceramic substrate 15 with solder 30.

Semiconductor element 20 may be a power semiconductor element using silicon (Si). In addition, semiconductor element 20 may be a wide band gap compound semiconductor using silicon carbide (SiC), gallium nitride (GaN), gallium arsenide (GaAs), or the like.

For example, a composition ratio of solder 30 is 96 mass% of tin (Sn), 3.5 mass% of silver (Ag), and 0.5 mass% of copper (Cu).

For example, the composition ratio of solder 30 may be 98.5 mass% of tin (Sn), 1 mass% of silver (Ag), and 0.5 mass% of copper (Cu). For example, the composition ratio of solder 30 may be 96 mass% of tin (Sn), 3 mass% of antimony (Sb), and 1 mass% of silver (Ag).

In addition, a copper (Cu)-tin (Sn) paste in which a copper powder is dispersed to obtain high heat resistance by isothermal solidification, or a nano-silver paste joined using low temperature firing of nano-silver particles may be used instead of solder 30.

Main electrode 211 of diode 21 and main electrode of IGBT 22 are electrically connected to main electrode terminal 62 using wire 40. For example, the material of wire 40 is aluminum. For example, the diameter of the wire is 0.3 mm.

The signal electrode such as the gate electrode of IGBT 22 is electrically connected to signal terminal 61 using wire 41. For example, the material of wire 41 is aluminum. For example, the diameter of the wire is 0.15 mm.

For example, the material of wires 40, 41 may be copper (Cu) or gold (Au). In addition, wires 40, 41 may be aluminum (Al)-coated copper (Cu) wires.

Instead of using wire bonding for circuit formation, ribbon bonding may be used, or the semiconductor element may be directly soldered to a plate-shaped electrode plate.

Signal terminal 61 and main electrode terminal 62 are insert-formed in case 60. For example, the outer dimensions of case 60 are 75 mm in length, 75 mm in width, and 8 mm in thickness.

Base plate 14, ceramic substrate 15, diode 21, IGBT 22, solder 30, wires 40, 41, sealing resin 7, signal terminal 61, and main electrode terminal 62 are disposed inside case 60.

In order to insulate and seal the inside of case 60, the inside of case 60 is sealed with sealing resin 7. Sealing resin 7 is formed by heating and curing a liquid sealing agent filled in case 60. For example, the liquid seal agent includes an epoxy resin in which a silica filler is dispersed, a softening agent, an antifoaming agent, and a flame retardant. The liquid seal agent is cured by being heated at 100 °C for 1.5 hours and further heated at 140 °C for 1.5 hours using, for example, the oven.

With reference to Fig. 17, a process of forming the test piece for the adhesion evaluation test of the second embodiment will be described. Fig. 17 illustrates a section of a portion of semiconductor device 1 where semiconductor element 20 does not exist.

Test piece 72 is formed from sealing resin 7 by processing using laser beam 6. Laser beam 6 is a laser for opening the sealing resin. First, sealing resin 7 is removed in a circular shape using laser beam 6 to form a recess 71. For example, an outermost surface diameter of recess 71 is 5.0 mm.

For example, an irradiation device of laser beam 6 is F/Alit manufactured by Shinohara Japan Co., Ltd. For example, a wavelength of laser beam 6 is 1064 nm. For example, maximum output of the laser beam 6 is 20 W.

Sealing resin 7 is further removed, and an outer peripheral portion is removed while the central portion of test piece 72 is left at a point of time when the remaining height of sealing resin 7 becomes, for example, 1.5 mm. For example, the diameter of the central portion of test piece 72 is 1.5 mm. In this way, test piece 72 is manufactured.

Test piece 72 is formed in a pudding cup shape. That is, test piece 72 is formed in a truncated cone shape. For example, the diameter of the lead frame interface of test piece 72 is 1.94 mm. For example, the diameter of the surface of test piece 72 is 1.5 mm. For example, the height of test piece 72 is 1.5 mm.

An advantageous effect of the second embodiment will be described below.

According to the method for manufacturing test piece 72 for the adhesion evaluation test of the second embodiment, the method for manufacturing test piece 72 for the adhesion test in which the phenomenon generated in the actual mass production mold is directly reflected can be provided similarly to the first embodiment.

According to the adhesion evaluation method of the second embodiment, test piece 72 for the adhesion evaluation test is formed on base member 10 from sealing resin 7 of semiconductor device 1. The shear peeling strength is measured using test piece 72 for the adhesion evaluation test. Consequently, the adhesion evaluation method in which the phenomenon generated in the actual mass production mold is directly reflected can be provided similarly to the first embodiment.

### Example

An example will be described below. The example has the same configuration, operation, and effect as those of the first embodiment described above unless otherwise specified. Consequently, in the example, the same component as that in the first embodiment is denoted by the same reference numeral, and the description thereof will not be repeated.

The method for producing the test piece for the adhesion evaluation test in the example will be described.

First, semiconductor device 1 is prepared. In the example, semiconductor device 1 includes lead frame 11, diode 21, IGBT 22, solder 30, wires 40, 41, and sealing resin 7.

The material of lead frame 11 is copper. The dimensions of lead frame 11 are 120 mm in length, 75 mm in width, and 0.6 mm in thickness.

The dimensions of diode 21 are 15 mm in length, 13 mm in width, and 0.2 mm in thickness. For example, the dimensions of IGBT 22 are 15 mm in length, 15 mm in width, and 0.2 mm in thickness. Diode 21 and IGBT 22 are die-bonded to die pad 112 of lead frame 11 with solder 30.

The composition ratio of solder 30 is 96.5 mass% of tin (Sn), 3 mass% of silver (Ag), and 0.5 mass% of copper (Cu). The melting point of solder 30 is 217 °C.

A main electrode 211 of diode 21 and a main electrode 221 of IGBT 22 are electrically connected to lead frame 11 using wire 40. The material of wire 40 is aluminum. The diameter of wire 40 is 0.3 mm.

A signal electrode 222 such as a gate electrode of IGBT 22 is electrically connected to lead frame 11 using wire 41. The material of wire 41 is aluminum. The diameter of wire 41 is 0.15 mm.

Heated sealing resin 7 is pressure-injected and then heat-cured while lead frame 11, semiconductor element 20, solder 30, and wires 40, 41 are sandwiched between molds (not illustrated), whereby resin sealing is completed. The mold (not illustrated) is heated to 170 °C. Sealing resin 7 is heated to 170 °C. Sealing resin 7 is an epoxy transfer mold resin containing a silica filler. Sealing resin 7 is pressure-injected and then heat-cured in the oven at 170 °C for 4 hours.

Subsequently, test piece 72 for the adhesion evaluation test is formed. Recess 71 is formed by removing sealing resin 7 in a circular shape using laser beam 6. The outermost surface diameter of recess 71 is 5.0 mm.

The irradiation device of laser beam 6 is F/Alit manufactured by Shinohara Japan Co., Ltd. The wavelength of laser beam 6 is 1064 nm. The maximum output of laser beam 6 is 20 W.

Sealing resin 7 is further removed, and an outer peripheral portion is removed while the central portion of test piece 72 is left at a point of time when the remaining height of sealing resin 7 becomes 1.5 mm. The diameter of the central portion of test piece 72 is 1.5 mm.

Test piece 72 is formed in a pudding cup shape. That is, test piece 72 is formed in a truncated cone shape. Diameter D1 of the lead frame interface of test piece 72 is 1.94 mm. Diameter D2 of the surface of test piece 72 is 1.5 mm. Height H of test piece 72 is 1.5 mm.

The adhesion evaluation method in the example will be described below.

In the adhesion evaluation method of the example, the adhesion is evaluated using the test piece manufactured by the method for manufacturing the test piece for the adhesion evaluation test.

In the adhesion evaluation method of the example, the shear peeling strength is measured using the test piece for the adhesion evaluation test.

Semiconductor device 1 in which test piece 72 is provided is fixed to a mounting table 80. In this state, test piece 72 is pushed by tool 90 until test piece 72 is broken.

The device used for evaluating the shear peeling strength is bond tester DAGE4000 manufactured by DAGE. The shear peeling strength test is performed at normal temperature. The height of the tip end of tool 90 is set to the height of 0.04 mm from lead frame 11. The shear rate pressing tool 90 is 0.3 mm/s.

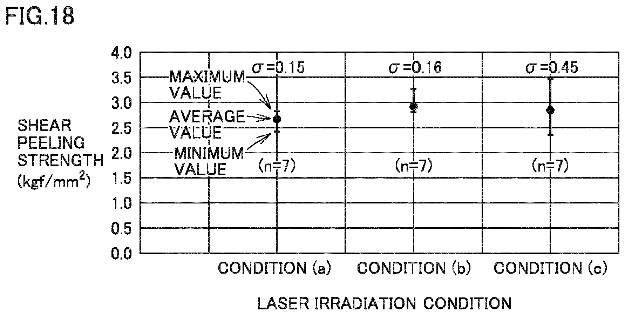

With reference to Fig. 18, the relationship between the laser irradiation condition and the shear peeling strength was examined. Fig. 18 is a graph illustrating the relationship between the laser irradiation condition (a resin remaining amount around the test piece) and the shear peeling strength. The shear peeling strength of test piece 72 was examined by changing the laser irradiation time. The height of test piece 72 is 1.5 mm. The diameter of the interface of lead frame 11 of test piece 72 is 1.94 mm.

The laser irradiation conditions are the following conditions (a), (b), (c). In the condition (a), the sealing resin remaining thickness around the test piece is greater than or equal to 0 mm and less than or equal to 0.07 mm. In the condition (b), the copper lead frame is exposed from the sealing resin around the test piece. In the condition (c), the periphery of the test piece is irradiated with the excessive laser beam. An average value and a standard deviation σ were calculated from seven (n = 7) measured values for each condition. In the condition (a), the standard deviation σ is 0.15 (σ = 0.15). In the condition (b), the standard deviation σ is 0.16 (σ = 0.16). In the condition (c), the standard deviation σ is 0.45 (σ = 0.45). However, in the condition (c), the periphery of the test piece is irradiated with the laser beam twice after the copper lead frame is exposed at the intensity of the laser beam capable of removing the sealing resin having the thickness of about 0.5 mm by one-time irradiation.

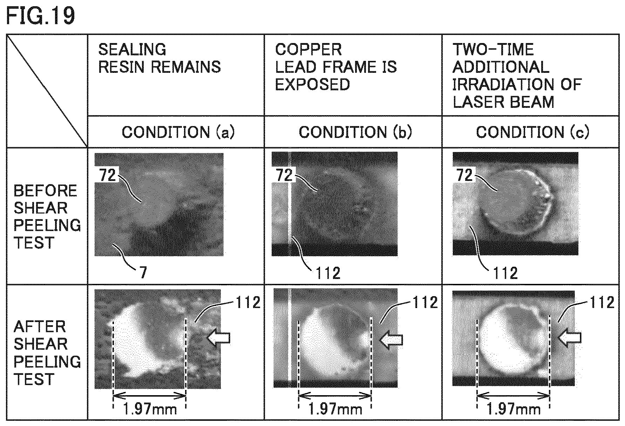

Fig. 19 illustrates the appearance of prepared test piece 72 and the appearance of the adhesive portion after the shear peeling test. In the condition (c), a burnt mark of the copper lead frame was observed around test piece 72. However, the copper lead frame was not cut into a concave shape, and the overall shape was not different from the condition (b).

The average value was not almost changed under each condition, but a variation of the measured value became large under the condition (c). From this, there is a possibility that heat is generated at the interface between the sealing resin and the lead frame due to the continuous irradiation of the laser beam even after the copper lead frame is exposed and the adhesion is reduced.

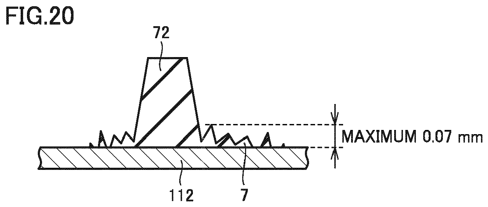

It was found that a measurement result of the small variation can be obtained by setting the thickness of the sealing resin left around the test piece to greater than or equal to 0 mm and less than or equal to 0.07 mm. However, the fact that the thickness of the sealing resin remaining around the test piece is 0.07 mm indicates that the irregularity of the sealing resin exists around the test piece and that the maximum value of a protrusion portion is 0.07 mm as illustrated in Fig. 20.

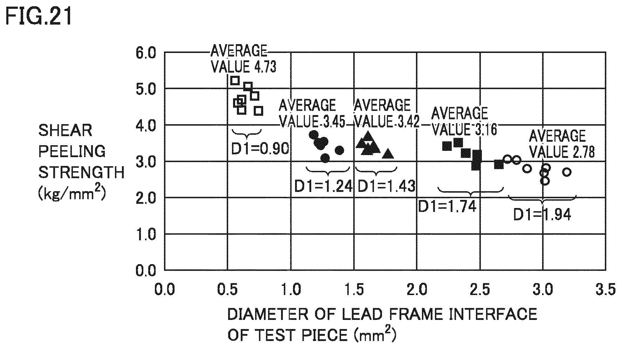

With reference to Fig. 21, the relationship between the diameter of the test piece and the shear peeling strength was examined. Fig. 21 is a graph illustrating the relationship between the diameter of the test piece and the shear peeling strength. Five specifications of test pieces were prepared. In each of the five specifications, diameter D1 of the interface of lead frame 11 of test piece 72 is 1.94 mm, 1.74 mm, 1.43 mm, 1.24 mm, 0.9 mm. Seven test pieces of five specifications were prepared. Each test piece was subjected to the shear peeling test. The average value of the shear peeling strength was calculated for each of the five specifications. As a result, the shear peeling strength was larger as diameter D1 of the interface of lead frame 11 of test piece 72 was smaller. That is, the shear peeling strength tended to increase as the adhesion area was smaller.

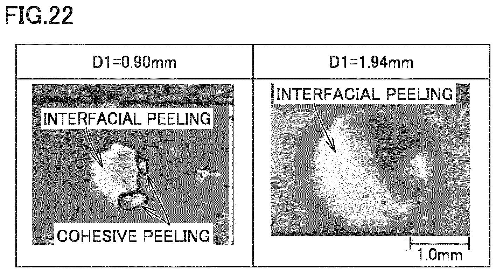

Fig. 22 illustrates the appearance after the shear peeling test when diameter D1 is 1.94 mm and 0.90 mm. When the appearances after the shear peeling test was compared when diameter D1 was 1.94 mm and 0.90 mm, the mode was almost interfacial peeling when diameter D1 was 1.94 mm, whereas the mode was cohesive peeling when diameter D1 was 0.90 mm. Thus, it is presumed that when the pudding cup of the test piece is thin, the deflection is generated against the load applied from the tool to apply the stress to the inside of the pudding cup separately from the interface. In the interfacial peeling, the peeling is generated at the interface, and the copper lead frame is completely exposed. In the cohesive peeling, the destruction is generated in a bulk portion of the resin.

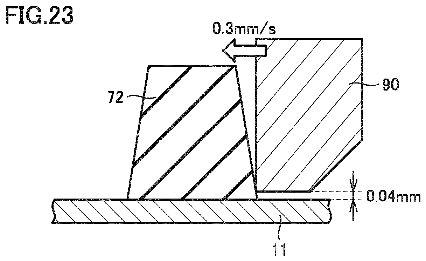

Fig. 23 is a sectional view illustrating the method of measuring the shear peeling strength of test piece 72. It is considered that when the diameter of test piece 72 decreases, the deflection of test piece 72 is easily generated up to the height that tool 90 hits test piece 72 and the shear peeling strength is measured to be large. It has been found that the shear peeling strength tends to increase as the height actually hit by tool 90 is increased.

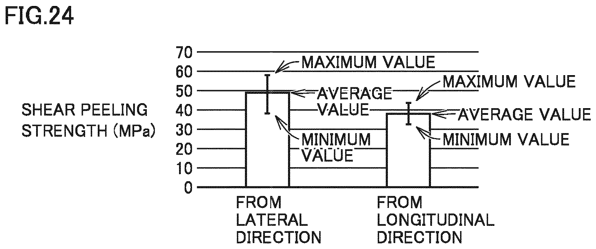

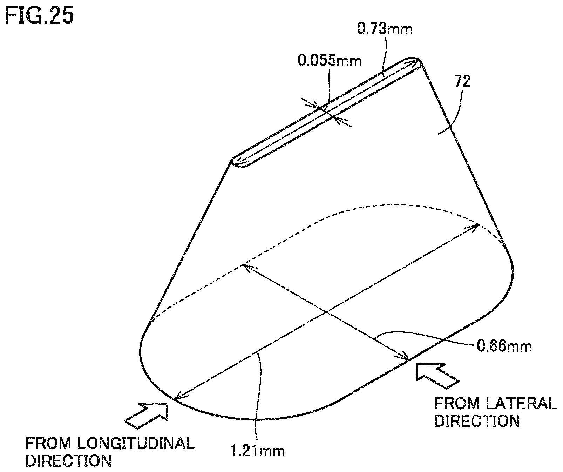

With reference to Figs. 24 and 25, the relationship between the direction pressed by the tool and the shear peeling strength was compared when the upper surface and the bottom surface of test piece 72 had a round corner rectangular shape. Fig. 24 compares the relationship between the direction in which the test piece is pushed by the tool and the shear peeling strength. Fig. 25 illustrates the shape of test piece 72 and the direction in which the test piece is pushed by the tool. The shear peeling strength was larger when test piece 72 was pushed in the lateral direction than when the test piece was pushed in the longitudinal direction. When test piece 72 is formed in the elliptical truncated cone shape, specifically, the upper surface and the bottom surface are formed in the rounded rectangular shape, the influence of the deflection can be excluded by pushing test piece 72 with the tool from the longitudinal direction even when the bottom area of test piece 72 is small.

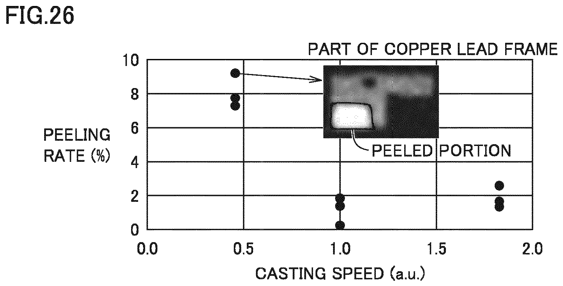

Fig. 26 illustrates the relationship between the casting speed and the peeling rate when a package in which the resin casting speed is changed is prepared and when a reflow heat resistance test is performed. Fig. 26 illustrates a scanning acoustic tomograph (SAT) image of a part of the copper lead frame. The peeling rate is defined as a ratio of the peeling area to the entire area of the copper lead frame. The casting speed indicates a numerical value when the median value is 1.0. A clear correlation between the casting speed and the peeling rate cannot be obtained, but there is a possibility that the physical property of the material such as a gelation time of the resin is affected.

The shear peeling strength before the reflow heat resistance test of the package in which the casting speed of the resin was changed was evaluated. The pudding cup was prepared at a position where a peeling generation rate was high in the reflow heat resistance test. Diameter D1 of the pudding cup was set to 0.9 mm due to the restriction of the area of the copper lead frame.

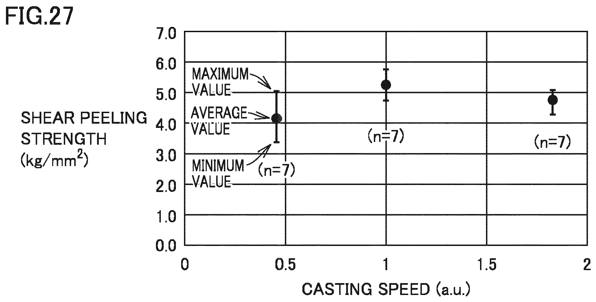

Fig. 27 illustrates the relationship between the casting speed of the resin and the shear peeling strength. It was found that the shear peeling strength was changed with respect to the resin casting speed.

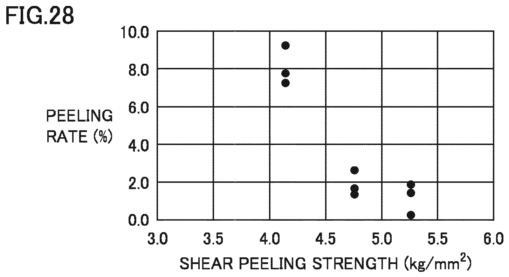

Fig. 28 illustrates correlation between the shear peeling strength and the peeling rate in the reflow heat resistance test by combining the results in Figs. 26 and 27. A negative correlation between the shear peeling strength and the peeling rate was found. The peeling rate in the reflow heat resistance test can be predicted by measuring the shear peeling strength using this technique.

### Third embodiment

A third embodiment has the same configuration, operation, and effect as those of the first embodiment described above unless otherwise specified. Consequently, in the third embodiment, the same component as that in the first embodiment is denoted by the same reference numeral, and the description thereof will not be repeated.

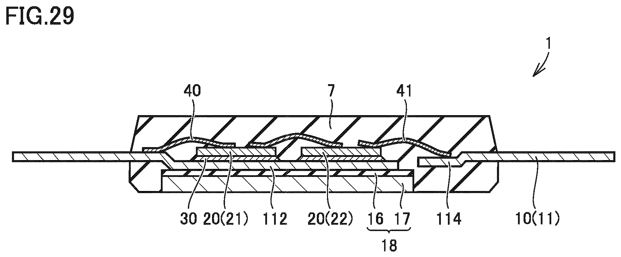

With reference to Figs. 29 to 31, a method for manufacturing the test piece for the adhesion evaluation test and an adhesion evaluation method according to the third embodiment will be described.

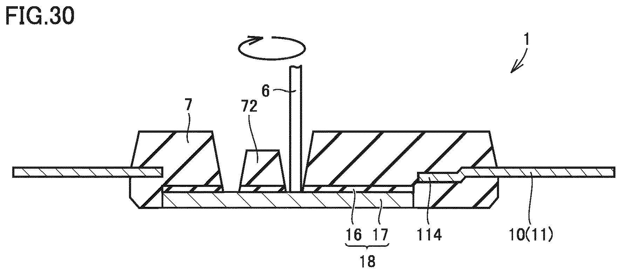

With reference to Figs. 29 and 30, a method for manufacturing the test piece for the adhesion evaluation test of the third embodiment will be described. With reference to Fig. 29, a process of preparing the semiconductor device in the method for manufacturing the test piece for the adhesion evaluation test according to the third embodiment will be described. Fig. 29 is a sectional view illustrating semiconductor device 1 in the method for manufacturing the test piece for the adhesion evaluation test of the third embodiment. As illustrated in Fig. 29, in semiconductor device 1, an insulating sheet 18 including insulating member 16 and metal member 17 is disposed under die pad 112. Insulating member 16 is an epoxy resin. Insulating member 16 is formed in a sheet shape. Insulating member 16 has an insulating property. For example, the material of metal member 17 is copper or aluminum.

With reference to Fig. 30, a process of forming the test piece for the adhesion evaluation test of the third embodiment will be described. Fig. 30 illustrates a section of a portion of semiconductor device 1 where semiconductor element 20 does not exist. As illustrated in Fig. 30, test piece 72 is formed by laser beam 6 so as to include sealing resin 7 and insulating member 16 in a portion where die pad 112 is not disposed. In this way, test piece 72 for the adhesion evaluation test is formed on insulating member 16 under base member 10 from sealing resin 7 of semiconductor device 1.

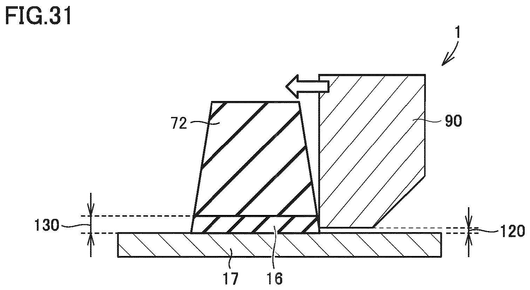

With reference to Fig. 31, a process of measuring the shear peeling strength in the adhesion evaluation method of the third embodiment will be described. Similarly to the first and second embodiments, as illustrated in Fig. 31, test piece 72 is pushed by tool 90. At this point, a height 120 of tool 90 is lower than a thickness 130 of insulating member 16. Height 120 of tool 90 is lower than thickness 130 of insulating member 16 by, for example, 0.1 mm. Thus, the shear strength at which the interface between insulating member 16 and metal member 17 is broken can be checked.

The adhesion between insulating member 16 and metal member 17 is required to be secured after insulating sheet 18 is sealed with the sealing resin 7. However, when the adhesion between insulating member 16 and metal member 17 is evaluated after sealing, the checking of the presence or absence of the peeling by an ultrasonic test or the like after the reliability test is a general method, and the presence or absence of the degradation is hardly quantitatively checked as the evaluation of the adhesion.

The influence of the injection process condition of sealing resin 7 on the adhesion strength of the interface between insulating member 16 and metal member 17 can be checked by the shear test method of the third embodiment. Thus, the appropriate process condition can be determined, so that the material development period of insulating member 16 can be shortened.

The above-described embodiments can be appropriately combined.

### REFERENCE SIGNS LIST

1: semiconductor device, 6: laser beam, 7: sealing resin, 10: base member, 11: lead frame, 14: base plate, 15: ceramic substrate, 16: insulating member, 17: metal member, 18: insulating sheet, 20: semiconductor element, 21: diode, 30: solder, 40, 41: wire, 60: case, 72: test piece, 80: mounting table, 90: tool, 100: mask, 110: etching solution, 120: height, 130: thickness

## Claims

1. A method for manufacturing a test piece (72) for an adhesion evaluation test, the method comprising:
preparing a semiconductor device (1) including a base member (10), a semiconductor element (20) mounted on the base member (10), and a sealing resin (7) to seal the base member (10) and the semiconductor element (20); and
forming the test piece (72) for the adhesion evaluation test on the base member (10) or on an insulating member (16) under the base member (10) from the sealing resin (7) of the semiconductor device (1),
**characterized in that**, the test piece (72) is formed in an elliptical truncated cone shape.

2. The method for manufacturing the test piece (72) for the adhesion evaluation test according to claim 1, wherein
the insulating member (16) is a sheet-like epoxy resin,
the semiconductor device (1) further includes a metal member (17), and the metal member (17) is disposed under the insulating member (16).

3. The method for manufacturing the test piece (72) for the adhesion evaluation test according to claim 1, wherein the test piece (72) is formed from the sealing resin (7) by processing using a laser beam.

4. The method for manufacturing the test piece (72) for the adhesion evaluation test according to claim 1, wherein the test piece (72) is formed from the sealing resin (7) by processing using an etching solution.

5. The method for manufacturing the test piece (72) for the adhesion evaluation test according to claim 1, further comprising:
measuring shear peeling strength using the test piece (72) for the adhesion evaluation test.

## Patentansprüche

1. Verfahren zur Herstellung eines Prüfstücks (72) für eine Adhäsionsprüfung, wobei das Verfahren umfasst:
Vorbereiten einer Halbleitervorrichtung (1), die ein Basisteil (10), ein an dem Basisteil (10) befestigtes Halbleiterelement (20) und ein Vergussharz (7) zum Vergießen des Basisteils (10) und des Halbleiterelements (20) umfasst; und
Bilden des Prüfstücks (72) für die Adhäsionsprüfung an dem Basisteil (10) oder an einem Isolationsteil (16) unter dem Basisteil (10) aus dem Vergussharz (7) der Halbleitervorrichtung (1),
**dadurch gekennzeichnet, dass**
das Prüfstück (72) in Form eines elliptischen Kegelstumpfs gebildet wird.

2. Verfahren zur Herstellung des Prüfstücks (72) für die Adhäsionsprüfung nach Anspruch 1, wobei
das Isolationsteil (16) ein schichtartiges Epoxidharz ist,
die Halbleitervorrichtung (1) ferner ein Metallteil (17) umfasst, und
das Metallteil (17) unter dem Isolationsteil (16) angeordnet ist.

3. Verfahren zur Herstellung des Prüfstücks (72) für die Adhäsionsprüfung nach Anspruch 1, wobei das Prüfstück (72) durch Verarbeitung unter Verwendung eines Laserstrahls aus dem Vergussharz (7) gebildet wird.

4. Verfahren zur Herstellung des Prüfstücks (72) für die Adhäsionsprüfung nach Anspruch 1, wobei das Prüfstück (72) durch Verarbeitung unter Verwendung einer Ätzlösung aus dem Vergussharz (7) gebildet wird.

5. Verfahren zur Herstellung des Prüfstücks (72) für die Adhäsionsprüfung nach Anspruch 1, ferner umfassend:
Messen einer Scher-Ablöse-Festigkeit unter Verwendung des Prüfstücks (72) für die Adhäsionsprüfung.

## Revendications

1. Procédé de fabrication d'une pièce d'essai (72) pour un essai d'évaluation d'adhérence, le procédé comprenant :
la préparation d'un dispositif semi-conducteur (1) comportant un élément de base (10), un élément semi-conducteur (20) monté sur l'élément de base (10), et une résine d'étanchéité (7) pour sceller l'élément de base (10) et l'élément semi-conducteur (20) ; et
la formation de la pièce d'essai (72) pour l'essai d'évaluation d'adhérence sur l'élément de base (10) ou sur un élément isolant (16) sous l'élément de base (10) à partir de la résine d'étanchéité (7) du dispositif semi-conducteur (1), **caractérisé en ce que**
la pièce d'essai (72) est formée en forme de cône tronqué elliptique.

2. Procédé de fabrication de la pièce d'essai (72) pour l'essai d'évaluation d'adhérence selon la revendication 1, dans lequel
l'élément isolant (16) est une résine époxy de type feuille,
le dispositif semi-conducteur (1) comporte en outre un élément métallique (17), et l'élément métallique (17) est disposé sous l'élément isolant (16).

3. Procédé de fabrication de la pièce d'essai (72) pour l'essai d'évaluation d'adhérence selon la revendication 1, dans lequel la pièce d'essai (72) est formée à partir de la résine d'étanchéité (7) par traitement à l'aide d'un faisceau laser.

4. Procédé de fabrication de la pièce d'essai (72) pour l'essai d'évaluation d'adhérence selon la revendication 1, dans lequel la pièce d'essai (72) est formée à partir de la résine d'étanchéité (7) par traitement à l'aide d'une solution d'attaque.

5. Procédé de fabrication de la pièce d'essai (72) pour l'essai d'évaluation d'adhérence selon la revendication 1, comprenant en outre :
la mesure de la résistance au pelage par cisaillement à l'aide de la pièce d'essai (72) pour l'essai d'évaluation d'adhérence.
